# EUROPEAN PATENT APPLICATION

(11) **EP 0 836 222 A1**
(43) Date of publication of application: **15.04.1998**
(21) Application number: 97117393.5
(22) Date of filing: 08.10.1997
(51) Int. Cl.: H01L 21/28, H01L 23/532

(54) **Interconnect structure comprising semiconductor material**

(30) Priority: 08.10.1996 US 28037 P
(71) Applicant: TEXAS INSTRUMENTS INCORPORATED, Dallas Texas 75265 (US)
(72) Inventor: Niuya, Takayuki, Plano, TX 75025 (US); Yang, Ming, Richardson, TX 75082 (US)
(74) Representative: Schwepfinger, Karl-Heinz, Dipl.-Ing.

(57) **Abstract**

An interconnect for a semiconductor device, comprising: a first region 304 over a substrate 300, said first region having a first resistivity; a second region 306 over said first region, said second region having a lower resistivity than said first region; and a third region 308 over said second region, said third region having a higher resistivity than said second region. The first region is preferably a layer of polysilicon deposited over a gate oxide layer 302. The second region is a silicide, such as tungsten disilicide, and the third region is preferably polysilicon.

## Description

### FIELD OF THE INVENTION

The present invention relates to semiconductor integrated circuits, and more particularly to transistors formed in a semiconductor integrated circuit.

### BACKGROUND OF THE INVENTION

Semiconductor device sizes are continually driven down by the demand for larger and more complicated integrated circuits.
As line widths become narrower, the sheet resistance contribution to line impedance increases. Consequently, for a given sheet resistance the advantages of further decreased scaling of gate width in a metal-oxide-semiconductor (MOS) transistor, for example, are offset by the interconnect resistance of the gate. These considerations prompted the evolution from polycrystalline silicon (polysilicon) gates to polycided gates, that is, polysilicon gates with an overlayer of a silicide such as titanium disilicide (TiSi₂), tungsten disilicide (WSi₂), or molybdenum disilicide (MoSi₂). Silicides not only provide the advantage of low resistivity, but also have been proven to be easily patterned and stable in process steps that occur following the formation of the gate interconnect. See, e.g. S. P. Murarka, Refractory silicides for integrated circuits, J. Vac. Sci. Technol., 17(4), Jul./Aug. 1980, pp. 775-792.

Despite the advantages provided by polycided interconnects, the fabrication of very narrow line widths with this type of interconnect continues to present problems. In particular, the refractory metals such as titanium , tungsten, or molybdenum that are the basis of the silicides have been shown to diffuse into masking layers resulting in wider mask images than intended. In addition, processes that involve silicides can be more complicated because of the fear that the refractory metal constituent of the silicide will contaminate process equipment, particularly the etching and cleaning apparatus. Aspects of the present invention are intended to address these problems.

### SUMMARY OF THE INVENTION

The producibility of interconnects such as are used as the word lines in dynamic random access memory integrated circuits is enhanced through the use of a polycide gate having a polysilicon capping layer over the silicide layer. In one embodiment of the invention, a first polysilicon layer is formed over a gate oxide layer. A silicide, preferably WSi₂, is formed over the first polysilicon layer followed by a second polysilicon layer over the layer of silicide. Completely capping the silicide layer with polysilicon inhibits the diffusion of the refractory metal component of the silicide, tungsten for example, into masking layers used to define the critical gate dimension. Such diffusion can cause etch characteristics in the masking layer that lead to an undesirable widening of the mask pattern. Another benefit of the capping layer is that the refractory metal component is much less likely to contaminate process equipment when covered with a polysilicon capping layer than when left uncovered.

### BRIEF DESCRIPTION OF THE DRAWINGS

The foregoing features of the present invention may be more fully understood from the following detailed description, read in con;unction with the accompanying drawings, wherein:
Figure 1 is a cross-sectional diagram of a prior art polycide gate structure;
Figures 2a to 2h are cross-sectional diagrams of the gate structure shown in Figure 1 at several process steps;
Figures 3a to 3j are cross-sectional diagrams of a gate structure in accordance with a preferred embodiment of the invention at several process steps; and
Figure 4 is a cross-sectional diagram of a cell in a dynamic random access memory integrated circuit.

### DETAILED DESCRIPTION OF PREFERRED EMBODIMENTS

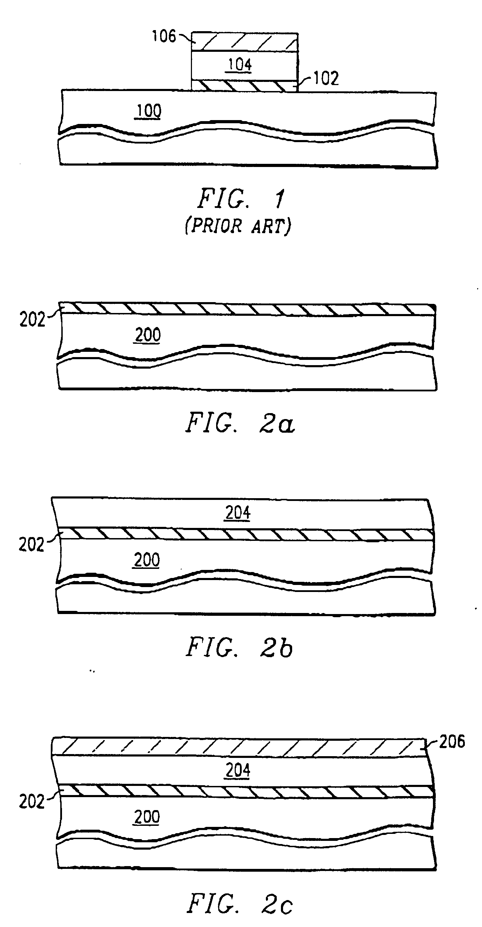

The typical multilayer polycide gate as may be found, for example, as the word line of a dynamic random access memory is shown in Figure 1. The gate comprises a thin gate oxide 102 over a silicon substrate 100, a layer of polysilicon 104 over the gate oxide, and a layer of silicide 106 over the polysilicon. The gate structure shown in Figure 1 has proven difficult to produce for very short gate lengths (the gate length is the width of the oxide/poly/silicide mesa viewed in cross-section in Figure 1). Possible reasons for this difficulty can be appreciated by examining a process for forming the gate structure of Figure 1. Figures 2a-2h show steps in such a process. In Figure 2a, a thin layer 202 of gate dielectric, typically silicon dioxide, is formed over a substrate 200. In Figure 2b, a layer 204 of polysilicon is formed over the gate dielectric. In Figure 2c, a silicide such as WSi₂, WSi, TaSi₂, TiSi₂, CoSi₂, or MoSi₂ is deposited over the polysilicon layer 204. WSi₂ is preferred for its low sheet resistance and stability when subjected to high process temperatures. Another reason that silicides in general are favored in this application is that they possess a lower thin film resistivity than is possible for polysilicon. The resistivity of polysilicon depends on the dopant, dopant concentration, and method of doping, but while highly doped polysilicon has a resistivity on the order of 1000 µΩ · cm, refractory disilicides of Mo, Ta, Ti, and W have respective resistivities of about 100-120, 50-65, 15-25, and 60-70 µΩ · cm.

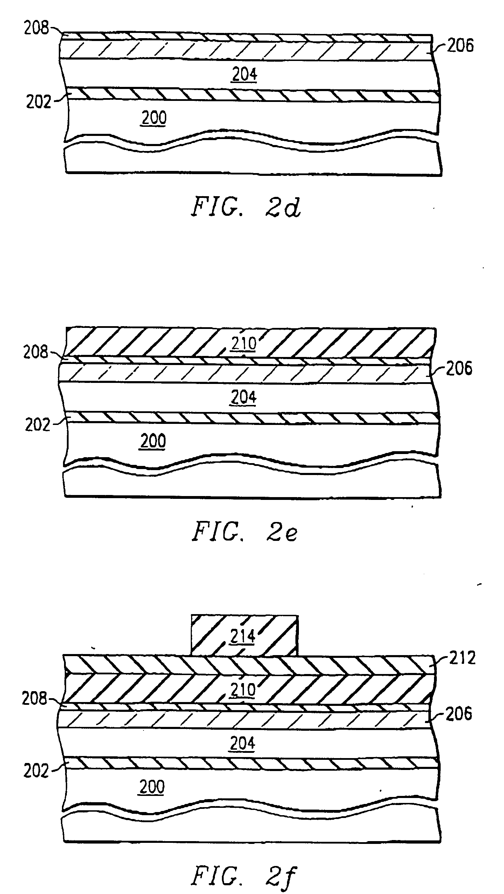

In Figures 2d and 2e, layers of silicon dioxide 208 (formed through decomposition of tetraethylorthosilicate (TEOS)) and silicon nitride 210 are formed over the silicide layer 204. The silicon dioxide layer 208 serves to match the stoichiometry between the silicide layer 206 and the nitride layer 208 that is used as a hard mask for the definition of the critical dimension of the structure, the gate length.

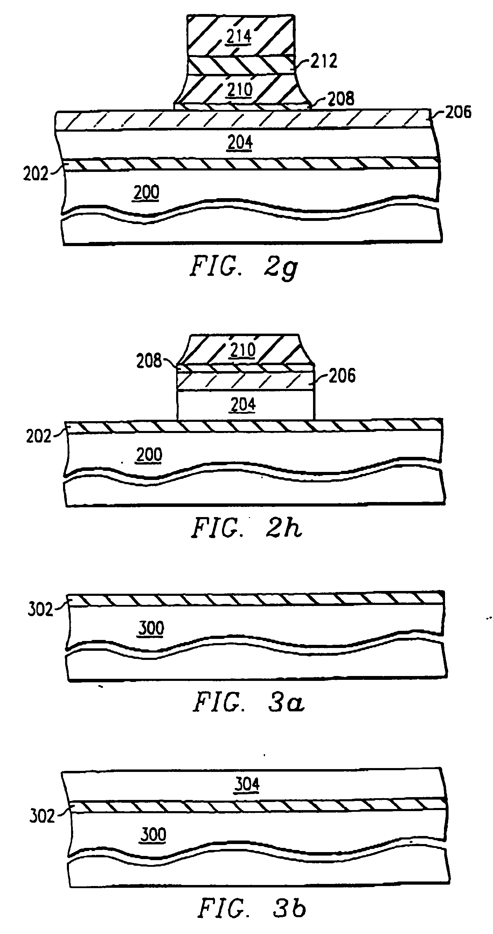

The patterning of the nitride hard mask layer 210 begins as shown in Figure 2f by depositing a buried anti-reflection coating 212 (BARC) over the nitride hard mask layer. Photoresist 214 is then deposited over the BARC layer and patterned to the desired dimension of the gate. The BARC layer 212 inhibits reflections during exposure of the photoresist 214 that can affect the photoresist patterning by producing undesirable standing waves. Once the photoresist is patterned, the structure is etched in a reactive ion etching apparatus to obtain the structure shown in Figure 2g. Using nitride layer 210 as a mask, the underlying silicide layer 206 and polysilicon layer 204 are removed in a standard manner.

Figure 2g shows a flaring of the etch profile at the base of the nitride hardmask layer 210. Such a profile is undesirable in that it results in a gate having a length greater than that defined in photoresist layer 214. The undesirable flaring is thought to be caused by contamination of the nitride layer 210 with metal from the silicide (tungsten, for example) diffusing through the oxide layer 208 into the lower portions of layer 210. The metal contamination in the nitride layer results in etch characteristics that depend upon the degree of contamination. Those portions of the nitride hardmask layer 210 closest to the silicide layer contain the most metal and etch more slowly than the less contaminated strata higher in nitride layer 210. The result is the flared etch profile of layer 210 shown in Figure 2g.

In one preferred embodiment of the invention, the problem of the flaring of the nitride hardmask layer is addressed by forming a protective polysilicon layer over the silicide layer prior to the deposition of the oxide and nitride hardmask layers. Figures 3a-3i show steps in a process for forming a gate structure having a shorter critical dimension than is possible with the process described above. In Figure 3a, a gate dielectric layer 302 of, for example, approximately 9 nm thickness is formed at a surface of a semiconductor substrate 300. The substrate is preferably silicon and the dielectric is preferably silicon dioxide or silicon nitride. The formation of the gate dielectric 302 is followed in Figure 3b by the formation of a polysilicon layer 304 having a thickness, for example, in the range of approximately 30 to 70 nm, but preferably about 50 nm. The polysilicon layer 304 is doped in situ with a dopant such as phosphorus to a concentration of approximately 4.5x10²⁰ cm⁻³. It should be noted that conductive material other than polysilicon could be used for the lower portion of the interconnect, but polysilicon is preferred because of its compatibility with existing processes and ease of handling. Alternatives to polysilicon include epitaxial silicon, silicides, nitrides, carbides, borides, refractory metals, TiW, aluminum, and combinations of these and other materials. In Figure 3c a silicide layer 306 comprising a material such as WSi, MoSi₂, TaSi₂, TiSi₂ or CoSi₂, but preferably WSi₂, is formed over the polysilicon layer 304. The thickness of the silicide layer 306 is, for example, in the range of approximately 100 to 140 nm, but preferably is about 120 nm. As shown in Figure 3d, a second polysilicon layer 308 is formed over the silicide layer 306. The second polysilicon layer 308 has a thickness, for example, in the range of approximately 30 to 70 nm, but is preferably about 50 nm. The second polysilicon layer 308 is doped in a manner similar to that described above for the lower polysilicon layer 304. As noted above, conductive material other than polysilicon may be appropriate for the upper portion of the interconnect, but polysilicon is preferred because of its compatibility with existing processes and ease of handling.

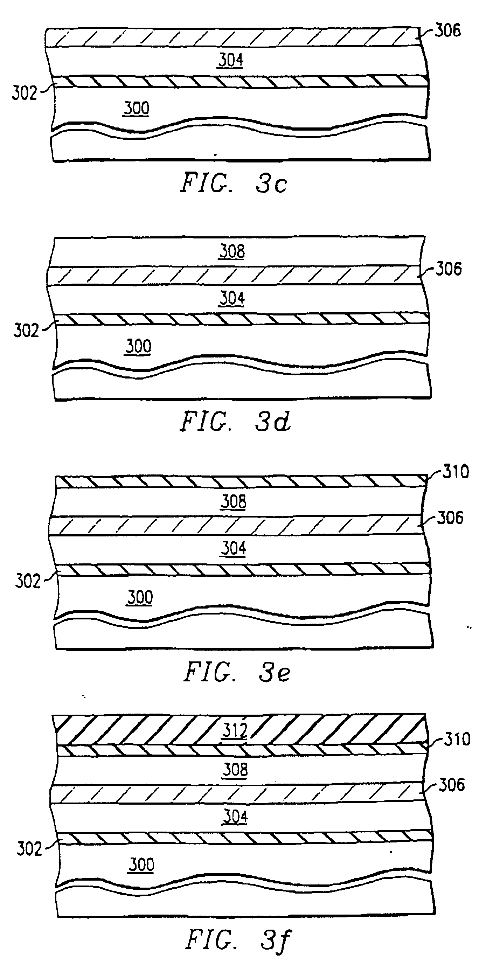

Referring now to Figure 3e, a silicon dioxide layer 310 is formed at the surface of the second polysilicon layer 308. The preferred technique is oxidation of the polysilicon surface to produce an oxide layer having a thickness, for example, of approximately 8 to 12 nm, but preferably about 10 nm. Alternative techniques could of course be used to form the oxide layer 310, such as decomposition of TEOS.

In Figure 3f a layer of silicon nitride 312 having a thickness, for example, in the range of approximately 140 to 260 nm, but preferably about 200 nm, is formed over the oxide layer 310. The oxide layer 310 serves as a stoichiometric buffer between the second polysilicon layer 308 and the nitride layer 312 that is used as a hard mask for the definition of the critical dimension of the structure, that is, the gate length.

The patterning of the nitride hardmask layer 312 begins by forming a BARC layer 314 over the nitride layer 312. The BARC layer has a thickness, for example, in the range of approximately 130 to 230 nm, but is preferably about 180 nm. Photoresist 316 is then spun to a thickness, for example, of about 0.8 to 1.0 µm over the BARC layer and patterned to define the gate dimension as shown in Figure 3g. The BARC layer 314 inhibits reflections during exposure of the photoresist 316 that can adversely affect the photoresist patterning by producing undesirable standing waves.

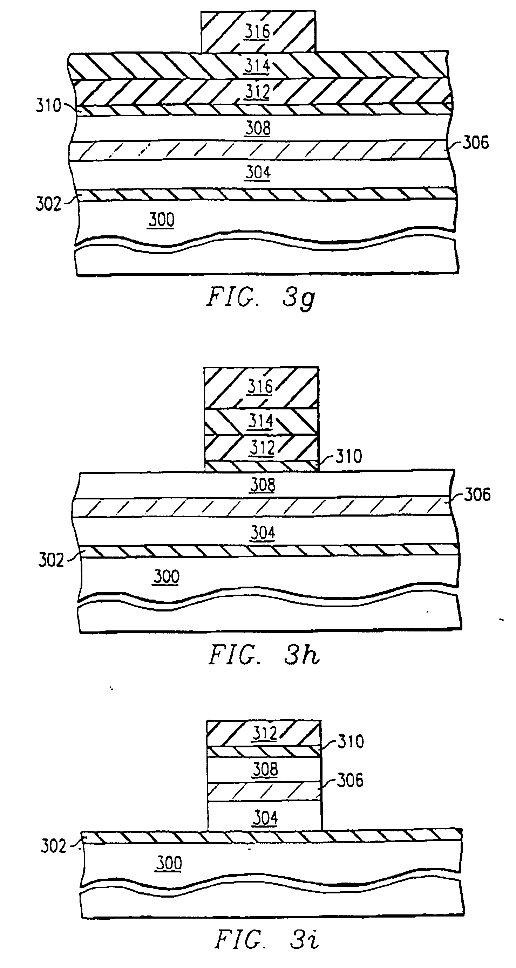

Once the photoresist is patterned, the structure is etched in a reactive ion etching apparatus to obtain the structure shown in Figure 3h. The BARC layer 314 is removed using a combination of CF₄, CHF₃, O₂, and Ar at flow rates of 20 sccm, 65 sccm, 10 sccm, and 95 sccm, respectively, and at a pressure of 55 mtorr and power of 450 W. The nitride hardmask layer 312 is removed using a combination of CHF₃, O₂, and Ar at flow rates of 65 sccm, 9 sccm, and 95 sccm, respectively, and at a pressure of 55 mtorr and power of 250 W. The duration of both the BARC and nitride etches is determined by endpoint detection, that is, detecting a change in the composition of the gas in the etch chamber indicating that the underlying layer has been reached. Oxide layer 310 is removed using a combination of CHF₃, O₂, and Ar at flow rates of 65 sccm, 7 sccm, and 95 sccm, respectively, and at a pressure of 55 mtorr and power of 250 W. The duration of this oxide etch is about 130% of the duration of the nitride etch that is determined by endpoint detection.

Using nitride layer 312 as a mask, the underlying second polysilicon layer 308, the silicide layer 306, and polysilicon layer 304 are removed in a standard manner using a Cl₂/O₂ etch to result in the structure shown in Figure 3i. The hardmask layer 312 and oxide layer 310 are then removed to leave the final gate structure shown in Figure 3j.

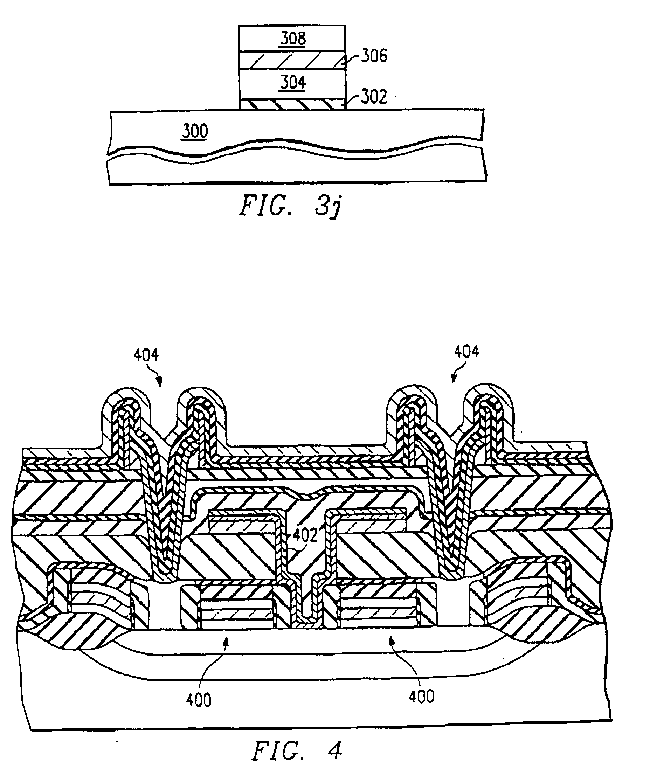

One application of the inventive concept is in improving the producibility of word line gate structures in DRAM integrated circuits. A cross-sectional diagram of a DRAM cell showing the relative locations of word lines 400, bit line 402 and storage capacitors 404 is shown in Figure 4.

An advantage of using the second polysilicon layer 308 is that the flaring of the nitride hardmask described in the process discussed above is virtually eliminated. The second polysilicon layer inhibits the diffusion of metal from the silicide layer 306 through the oxide layer 310 into the nitride hardmask 312 by completely covering the silicide layer and isolating it from the nitride hardmask 312. Since the lower portions of the hardmask layer are not contaminated with metal as in the process described above, the hardmask layer etches uniformly and produces a near-vertical sidewall. The result is a hardmask pattern dimension that closely matches that of the photoresist pattern and the desired gate dimension. The addition of the second polysilicon layer thus allows the reliable formation of the very narrow gate structures that are important to the more complicated and higher-performing circuits demanded in the future.

Another advantage of using the second polysilicon capping layer is that the metal of the silicide, tungsten for example, is generally prevented from contaminating post-etch process equipment such as ashers and wet clean hoods. The tendency of metal, particularly tungsten, to escape from exposed surfaces has forced the use of separate process equipment in the past to prevent wafer contamination with metal. The complete capping of the silicide layer with polysilicon allows the use of the same equipment for polycide gate operations as well as for others.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

## Claims

1. A semiconductor device including an interconnect, said interconnect comprising:
a first region formed over a substrate, said first region comprising a metal; and
a semiconductor region substantially covering and abutting said first region.

2. The semiconductor device of Claim 1, wherein said metal is a refractory metal.

3. The semiconductor device of Claim 1, wherein said first region comprises a metal silicide.

4. The semiconductor device of Claim 1, wherein said first region comprises tungsten disilicide.

5. The semiconductor device of Claim 1, wherein said first region comprises a refractory metal silicide and said second region comprises silicon.

6. The semiconductor device of Claim 5, wherein said silicon is polycrystalline silicon.

7. The semiconductor device of Claim 5, wherein said refractory metal silicide is selected from a group consisting of tungsten disilicide, tungsten silicide, tantalum disilicide, titanium disilicide, cobalt disilicide, and molybdenum disilicide.

8. A semiconductor device including a gate interconnect, said gate interconnect comprising:
a first conductive region formed over a substrate;
a silicide region formed over said first conductive region; and
a second conductive region formed over said silicide region.

9. The semiconductor device of Claim 8, wherein said first and second conductive regions are silicon.

10. The semiconductor device of Claim 9, wherein said silicon is polycrystalline silicon.

11. The semiconductor device of any of Claims 8 to 10, wherein said silicide region is formed from a refractory metal silicide.

12. The semiconductor device of any of Claims 8 to 11, wherein said silicide region is formed from a material selected from a group consisting of tungsten disilicide, tungsten silicide, tantalum disilicide, titanium disilicide, cobalt disilicide, and molybdenum disilicide.

13. The semiconductor device of any of Claims 8 to 11, wherein said silicide region comrpises tungsten disilicide.

14. A dynamic random access memory integrated circuit including a word line, said word line comprising:
a first silicon region formed over a substrate;
a silicide region formed over said first silicon region; and
a second silicon region formed over said silicide region.

15. The dynamic random access memory integrated circuit of Claim 14, wherein said first and second silicon regions comprise polycrystalline silicon.

16. The dynamic random access memory integrated circuit of Claim 14 or Claim 15, wherein said silicide region comprises a refractory metal silicide.

17. The dynamic random access memory integrated circuit of Claim 16, wherein said refractory metal silicide is tungsten disilicide.

18. The dynamic random access memory integrated circuit of any of Claims 14 to 17, wherein said silicide region comprises a material selected from a group consisting of tungsten disilicide, tungsten silicide, tantalum disilicide, titanium disilicide, cobalt disilicide, and molybdenum disilicide.

19. The dynamic random access memory integrated circuit of any of Claims 15 to 18, wherein said polycrystalline silicon is doped.
